# EUROPEAN PATENT APPLICATION

(11) **EP 4 651 637 A1**
(43) Date of publication of application: **19.11.2025**
(21) Application number: 24741766.0
(22) Date of filing: 15.01.2024
(51) Int. Cl.: H05K 1/14, H05K 3/28, H05K 1/11, H01L 23/498, G02F 1/1333

(54) **FLEXIBLE CIRCUIT BOARD, COF MODULE, AND ELECTRONIC DEVICE INCLUDING SAME**

(30) Priority: 13.01.2023 KR 20230005728
(71) Applicant: LG INNOTEK CO. LTD, Gangseo-gu Seoul 07796 (KR)
(72) Inventor: CHAE, Sung Min, Seoul 07796 (KR); LIM, Jun Young, Seoul 07796 (KR); YOON, Hyung Kyu, Seoul 07796 (KR)
(74) Representative: M. Zardi & Co S.A.
(86) International application number: PCT/KR2024/000688
(87) International publication number: WO 2024/151145

(57) **Abstract**

A flexible circuit board according to an embodiment includes a substrate including a first surface and a second surface opposite to the first surface; a first circuit pattern disposed on the first surface; a second circuit pattern disposed on the first surface and the second surface; a third circuit pattern disposed on the first surface and the second surface; a first protective layer disposed on the first surface; and a second protective layer disposed on the second surface, wherein a chip mounting region is defined on the first surface, wherein the first circuit pattern includes a first pad part connected to a chip on the chip mounting region; a second pad part connected to an external printed circuit board; and a first wiring part connected to the first pad part and the second pad part, wherein the second circuit pattern includes a third pad part connected to the chip; a fourth pad part connected to an external display panel; and a second wiring part connected to the third pad part and the fourth pad part, wherein the third circuit pattern includes a fifth pad part connected to the chip; a sixth pad part connected to the display panel; and a third wiring part connected to the fifth pad part and the sixth pad part, wherein the second circuit pattern includes a first via connecting a second wiring part on the first surface and a second wiring part on the second surface, wherein the second wiring part is defined by a first length which is a distance from an end of the fourth pad part to a first via closest to the fourth pad part; and a second length which is a length of the fourth pad part, and wherein the first length is longer than the second length.

## Description

### [Technical Field]

An embodiment relates to a flexible circuit board, COF module, and electronic device including same.

### [Background Art]

Recently, various electronic products are becoming thinner, smaller, and lighter. Accordingly, various studies are being conducted to mount semiconductor chips at high density in narrow areas of electronic products.

COF (Chip On Film) includes a flexible substrate. Accordingly, the COF can be applied to a flexible display. For example, the COF can be applied to various wearable electronic devices. In addition, the COF method can form a fine pitch. Accordingly, it can be applied to high-resolution displays.

The COF is mounted on a flexible circuit board in a form of a thin film with a semiconductor chip. For example, the semiconductor chip can be an integrated circuit (IC) chip or a large scale integrated circuit (LSI) chip.

The chip can be connected to an external circuit board and a display panel through a circuit pattern. For example, a pad part is disposed on one end and another end of the circuit pattern, respectively. one pad part is electrically connected to a terminal of the chip. In addition, another pad part may be connected to terminals of the circuit board and the display panel. Accordingly, the chip, the circuit board, and the display panel are electrically connected through the COF. Accordingly, a signal may be transmitted to the display panel through the circuit pattern.

Meanwhile, the flexible circuit board may be flexible. Accordingly, when connected to the circuit board and the display panel, the flexible circuit board may be bent in one direction. That is, the flexible circuit board includes a bending region.

When the bending region and a via overlap, a position of the via may change due to stress.

Therefore, a new structure of a flexible circuit board, a COF module, and an electronic device including the same that can solve the above problems are required.

As a patent related to the flexible circuit board, Korean Patent No. KR10-0618898 (2006.09.01) is disclosed.

### [Disclosure]

### [Technical Problem]

An embodiment provides a flexible circuit board having various designs, a COF module, and an electronic device including the same.

An embodiment provides a flexible circuit board, a COF module and an electronic device including the same having improved reliability.

### [Technical Solution]

A flexible circuit board according to an embodiment comprises a substrate including a first surface and a second surface opposite to the first surface; a first circuit pattern disposed on the first surface; a second circuit pattern disposed on the first surface and the second surface; a third circuit pattern disposed on the first surface and the second surface; a first protective layer disposed on the first surface; and a second protective layer disposed on the second surface, wherein a chip mounting region is defined on the first surface, wherein the first circuit pattern includes a first pad part connected to a chip on the chip mounting region; a second pad part connected to an external printed circuit board; and a first wiring part connected to the first pad part and the second pad part, wherein the second circuit pattern includes a third pad part connected to the chip; a fourth pad part connected to an external display panel; and a second wiring part connected to the third pad part and the fourth pad part, wherein the third circuit pattern includes a fifth pad part connected to the chip; a sixth pad part connected to the display panel; and a third wiring part connected to the fifth pad part and the sixth pad part, wherein the second circuit pattern includes a first via connecting a second wiring part on the first surface and a second wiring part on the second surface, wherein the second wiring part is defined by a first length which is a distance from an end of the fourth pad part to a first via closest to the fourth pad part; and a second length which is a length of the fourth pad part, and wherein the first length is longer than the second length.

### [Advantageous Effects]

The flexible circuit board according to the embodiment can control a first length of a region between a pad part and a via. The first length is defined as a length from an end of the second protective layer to a first via of a first via group closest to the end.

Accordingly, the flexible circuit board according to the embodiment can be bent once more in a region having the first length. Accordingly, a bezel region of a display panel can be reduced.

In addition, the flexible circuit board does not bend in a region where the via is disposed.

Accordingly, when the flexible circuit board is bent, stress can be prevented from being transmitted to the via. Accordingly, an alignment of the via can be prevented from being misaligned due to the stress. In addition, a shape or size of the via can be prevented from being changed.

### [Description of Drawings]

FIG. 1 is a drawing for explaining a top view of a flexible circuit board according to an embodiment.
FIG. 2 is a drawing for explaining a bottom view of a flexible circuit board according to an embodiment.
FIG. 3 is a drawing showing an enlarged view of region A of FIG. 1.
FIG. 4 is a drawing showing an enlarged view of region B of FIG. 1.
FIG. 5 is a drawing showing an enlarged view of region C of FIG. 2.
FIG. 6 is a drawing showing an enlarged view of region D of FIG. 2.
FIG. 7 is a drawing showing an enlarged view of region E of FIG. 1.
FIG. 8 is a drawing showing an enlarged view of region F of FIG. 1.
FIG. 9 and FIG. 10 are drawings for explaining a shape in which a COF module is bent.
FIG. 11 is a drawing showing an enlarged view of region G of FIG. 2.
FIG. 12 and FIG. 13 are drawings for explaining a shape in which a COF module is bent according to an embodiment.
FIGS. 14 and 15 are cross-sectional views taken along region A-A' of FIG. 3.
FIGS. 16 to 19 are drawings illustrating various bending shapes of a COF module including a flexible circuit board according to an embodiment.
FIGS. 20 to 22 are drawings of an electronic device including a flexible circuit board according to an embodiment.

### [Modes of the Invention]

Hereinafter, embodiments of the present disclosure will be described in detail with reference to the accompanying drawings. However, the spirit and scope of the present disclosure is not limited to a part of the embodiments described, and may be implemented in various other forms, and within the spirit and scope of the present disclosure, one or more of the elements of the embodiments may be selectively combined and redisposed.

In addition, unless expressly otherwise defined and described, the terms used in the embodiments of the present disclosure (including technical and scientific terms) may be construed the same meaning as commonly understood by one of ordinary skill in the art to which the present disclosure belongs, and the terms such as those defined in commonly used dictionaries may be interpreted as having a meaning that is consistent with their meaning in the context of the relevant art.

In addition, the terms used in the embodiments of the present disclosure are for describing the embodiments and are not intended to limit the present disclosure. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present disclosure, the terms such as first, second, A, B, (a), and (b) may be used. These terms are only used to distinguish the elements from other elements, and the terms are not limited to the essence, order, or order of the elements.

In addition, when an element is described as being "connected", "coupled", or "contacted" to another element, it may include not only when the element is directly "connected" to, "coupled" to, or "contacted" to other elements, but also when the element is "connected", "coupled", or "contacted" by another element between the element and other elements.

In addition, when described as being formed or disposed "on (over)" or "under (below)" of each element, the "on (over)" or "under (below)" may include not only when two elements are directly connected to each other, but also when one or more other elements are formed or disposed between two elements.

Further, when expressed as "on (over)" or "under (below)", it may include not only the upper direction but also the lower direction based on one element.

In addition, in a following description, a first direction 1D may be defined in a width direction of the flexible circuit board, and a second direction 2D may be defined in a length direction of the flexible circuit board.

Meanwhile, in drawings below, for the convenience of explanation, all circuit patterns disposed under a protective layer are drawn in solid lines.

Hereinafter, a flexible circuit board, a COF module, and an electronic device including the same according to an embodiment will be described with reference to the drawings.

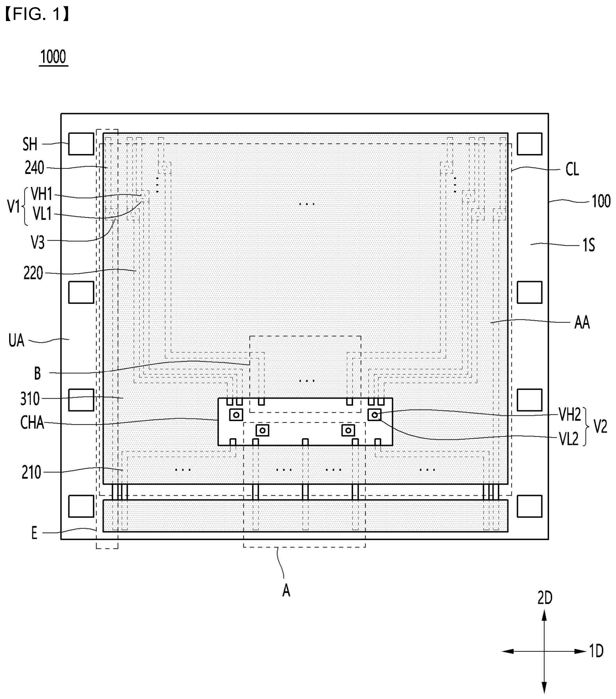

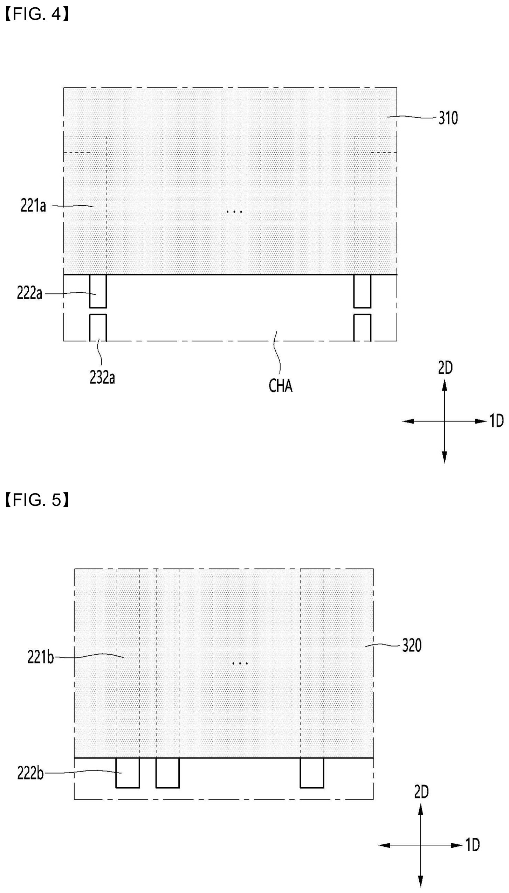

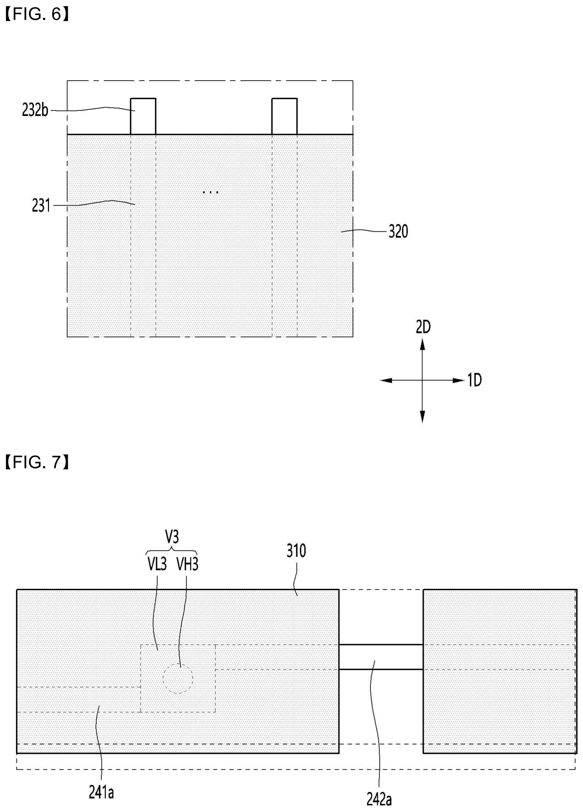

Referring to FIGS. 1 to 6, a flexible circuit board 1000 according to an embodiment may include a substrate 100, a circuit pattern, and a protective layer.

The substrate 100 may include a first surface 1S and a second surface 2S opposite to the first surface. The circuit pattern and the protective layer may be disposed on the first surface 1S and the second surface 2S.

The substrate 100 may include a cutting line CL. The flexible circuit board 1000 may be cut along the cutting line CL. In detail, the circuit pattern, the protective layer, and the chip are disposed on the substrate 100. Next, the substrate 100 is cut along the cutting line CL. Accordingly, a COF module 2000 can be manufactured.

The substrate 100 can include an active region AA and an unactive region UA. The active region AA and the unactive region UA can be distinguished by the cutting line CL. In detail, the active region AA can be defined as an inner region of the cutting line CL. In addition, the unactive region UA can be defined as an outer region of the cutting line CL.

The circuit pattern, the protective layer, and the chip can be disposed in the active region AA. In addition, a dummy pattern and a sprocket hole SH can be disposed in the unactive region UA. The dummy pattern can increase a strength of the substrate 100. As a result, the flexible circuit board 1000 can be prevented from being bent. In addition, the flexible circuit board 1000 can be rolled or unrolled in a roll-to-roll manner by the sprocket hole SH.

The substrate 100 may include a chip mounting region CHA. The chip mounting region CHA may be disposed inside the active region AA. The chip is disposed in the chip mounting region CHA. In addition, pad parts of the circuit pattern may be disposed inside the chip mounting region CHA. In addition, the protective layer is not disposed on the chip mounting region CHA.

The substrate 100 may include a flexible material. For example, the substrate 100 may include polyimide (PI). However, the embodiment is not limited thereto. The substrate 100 may include a polymer material such as polyethylene terephthalate (PET) or polyethylene naphthalate (PEN).

The substrate 100 may have a thickness of 20 µm to 100 µm. For example, the substrate 100 may have a thickness of 25 µm to 50 µm. For example, the substrate 100 may have a thickness of 30 µm to 40 µm. If the thickness of the substrate 100 exceeds 100 µm, an overall thickness of the flexible circuit board may increase. As a result, flexible characteristics of the flexible circuit board may be reduced. In addition, if the thickness of the substrate 100 is less than 20 µm, the flexible circuit board 1000 may be damaged. In detail, when the chip is mounted on the flexible circuit board 1000, heat and pressure are transmitted to the substrate 100. As a result, the substrate may be damaged.

The circuit pattern and the protective layer may be disposed on the substrate 100. In detail, the circuit pattern and the protective layer may be disposed in the active region AA and the unactive region UA.

The circuit pattern may include a first circuit pattern 210, a second circuit pattern 220, a third circuit pattern 230, and a fourth circuit pattern 240. In addition, the protective layer may include a first protective layer 310 and a second protective layer 320.

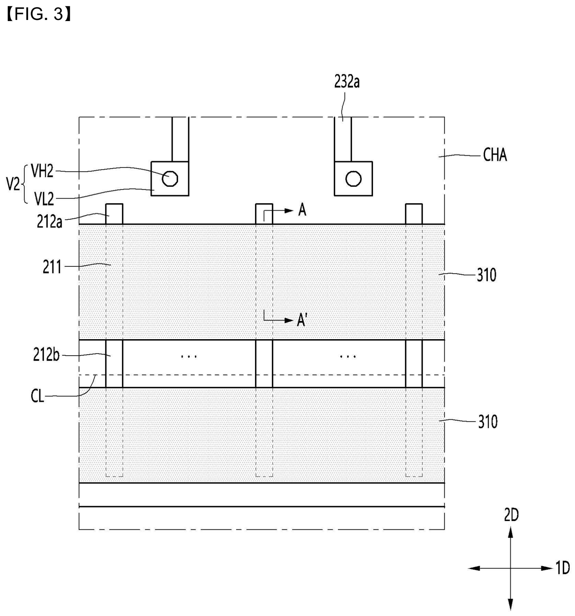

Referring to FIG. 1 and FIG. 3, the first circuit pattern 210 may be disposed on the first surface 1S. The first circuit pattern 210 may include a first wiring part 211, a first pad part 212a, and a second pad part 212b. The first wiring part 211, the first pad part 212a, and the second pad part 212b may include a same material. In addition, the first wiring part 211, the first pad part 212a, and the second pad part 212b may be formed integrally.

The first pad part 212a may be disposed inside the chip mounting region CHA. Accordingly, the first pad part 212a may be connected to a terminal of the chip. Accordingly, the first circuit pattern 210 and the chip may be connected.

In addition, the second pad part 212b may be disposed outside the chip mounting region CHA. The second pad part 212b may be connected to a terminal of an external circuit board. Accordingly, the first circuit pattern 210 and the circuit board may be connected.

Meanwhile, the second pad part 212b may be a first test pad part. In detail, the first circuit pattern 210 can be tested before connecting the circuit board and the second pad part 212b. For example, For example, the second pad part 212b can be used to check whether the first circuit pattern is open or shorted.

In addition, the first wiring part 211 can be disposed between the first pad part 212a and the second pad part 212b. That is, the first wiring part 211 can connect the first pad part 212a and the second pad part 212b. Accordingly, the chip and the circuit board can be connected. Accordingly, a signal generated from the chip can be transmitted to the circuit board.

The first protective layer 310 can be disposed on the first circuit pattern 210. In detail, the first protective layer 310 can be disposed on a region excluding the first pad part 212a and the second pad part 212b.

Referring to FIG. 1, FIG. 2, FIG. 4 and FIG. 5, the second circuit pattern 220 may be disposed on the first surface 1S and the second surface 2S. The second circuit pattern 220 may include a second wiring part 221a and 221b, a third pad part 222a, a fourth pad part 222b and a first via V1. The second wiring part 221a and 221b, the third pad part 222a and the fourth pad part 222b may include a same material. In addition, the second wiring part 221a and 221b, the third pad part 222a and the fourth pad part 222b may be formed integrally.

In addition, the first protective layer 310 or the second protective layer 320 is disposed on the second wiring part 221a and 221b. In addition, the first protective layer 310 or the second protective layer 320 is not disposed on the third pad part 222a and the fourth pad part 222b.

The third pad part 222a may be disposed on the first surface 1S. The third pad part 222a may be disposed inside the chip mounting region CHA. Accordingly, the third pad part 222a may be connected to a terminal of the chip. Accordingly, the second circuit pattern 220 and the chip may be connected.

In addition, the fourth pad part 222b may be disposed on the second surface 2S. The fourth pad part 222b can be connected to a terminal of an external display panel. Accordingly, the second circuit pattern 220 and the display panel can be connected.

The second wiring part can include a second-first wiring part 221a and a second-second wiring part 221b. The second-first wiring part 221a is disposed on the first surface 1S. The second-second wiring part 221b is disposed on the second surface 2S. The second wiring part can connect the third pad part 222a and the fourth pad part 222b. In detail, the second-first wiring part 221a can be connected to the third pad part 222a. In addition, the second-second wiring part 221b may be connected to the fourth pad part 222b.

Accordingly, the chip and the display panel may be connected. Accordingly, a signal generated from the chip may be transmitted to the display panel.

The first protective layer 310 and the second protective layer 320 may be disposed on the second circuit pattern 220. In detail, the first protective layer 310 may be disposed on the second circuit pattern 220 on the first surface 1S. In addition, the second protective layer 320 may be disposed on the second circuit pattern 220 on the second surface 2S. The first protective layer 310 and the second protective layer 320 may be disposed on a region excluding the third pad part 222a and the fourth pad part 222b.

The second-first wiring part 221a and the second-second wiring part 221b may be connected to each other. In detail, the second-first wiring part 221a and the second-second wiring part 221b may be connected through the first via V1. The first via V1 may be disposed on the first surface 1S and the second surface 2S. The first via V1 on the first surface 1S and the first via V1 on the second surface 2S may be disposed at positions corresponding to each other.

The first via V1 includes a first via land VL1 and a first via hole VH1. The first via hole VH1 is formed inside the first via land VL1. A conductive material may be disposed in the first via hole VH1. Accordingly, the second-first wiring part 221a and the second-second wiring part 221b may be electrically connected.

Meanwhile, the second circuit pattern 220 may include a second test pad part TP2. The second test pad part TP2 may be disposed on the second surface 2S. The second test pad part TP2 may be disposed in the unactive region UA. In addition, a second protective layer 320 is not disposed on the second test pad part TP2. The second test pad part TP2 can be connected to the second-second wiring part 221b. In detail, the second test pad part TP2 can be formed integrally with the second-second wiring part 221b.

The second circuit pattern 220 can be tested before connecting the display panel and the fourth pad part 222b. For example, the second test pad part TP2 may be used to check whether the second circuit pattern is open or shorted

Referring to FIGS. 1, 2, 3, and 6, the third circuit pattern 230 can be disposed on the first surface 1S and the second surface 2S. The third circuit pattern 230 may include a third wiring part 231, a fifth pad part 232a, a sixth pad part 232b, and a second via V2. The third wiring part 231, the fifth pad part 232a, and the sixth pad part 232b may include a same material. In addition, the third wiring part 231, the fifth pad part 232a, and the sixth pad part 232b may be formed integrally.

The fifth pad part 232a may be disposed on the first surface 1S. The fifth pad part 232a may be disposed inside the chip mounting region CHA. Accordingly, the fifth pad part 232a may be connected to a terminal of the chip. By this, the third circuit pattern 230 and the chip can be connected.

In addition, the sixth pad part 232b can be disposed on the second surface 2S. The sixth pad part 232b can be connected to a terminal of an external display panel. By this, the third circuit pattern 230 and the display panel can be connected.

In addition, the third wiring part 231 can connect the fifth pad part 232a and the sixth pad part 232b. Accordingly, the chip and the display panel can be connected. Accordingly, a signal generated from the chip can be transmitted to the display panel.

The first protective layer 310 and the second protective layer 320 can be disposed on the third circuit pattern 230. In detail, the first protective layer 310 may be disposed on the third circuit pattern 230 on the first surface 1S. In addition, the second protective layer 320 may be disposed on the third circuit pattern 230 on the second surface 2S. The first protective layer 310 and the second protective layer 320 may be disposed on a region excluding the fifth pad part 232a and the sixth pad part 232b.

The fifth pad part 232a and the third wiring part 231 on the second surface 2S may be connected to each other. In detail, the fifth pad part 232a and the third wiring part 231 may be connected through the second via V2. The second via V2 may be disposed on the first surface 1S and the second surface 2S. The second via V2 on the first surface 1S and the second via V2 on the second surface 2S may be disposed at positions corresponding to each other.

The second via V2 includes a second via land VL2 and a second via hole VH2. The second via hole VH2 is formed inside the second via land VL2. A conductive material may be disposed in the second via hole VH2. Accordingly, the fifth pad part 232a and the third wiring part 231 may be electrically connected.

Meanwhile, the third circuit pattern 230 may include a third test pad part TP3. The third test pad part TP3 may be disposed on the second surface 2S. The third test pad part TP3 may be disposed in the unactive region UA. In addition, the second protective layer 320 is not disposed on the third test pad part TP3. The third test pad part TP3 can be connected to the third wiring part 231. In detail, the third test pad part TP3 can be formed integrally with the third wiring part 231.

The third circuit pattern 230 can be tested before connecting the display panel and the sixth pad part 232b. For example, the third test pad part TP3 may be used to check whether the third circuit pattern is open or shorted.

Referring to FIG. 1, FIG. 7, and FIG. 8, the fourth circuit pattern 240 can be disposed on the first surface 1S and the second surface 2S. The fourth circuit pattern 240 may include a fourth wiring part 241a and 241b, a seventh pad part 242a, an eighth pad part 242b, and a third via V3. The fourth wiring part 241a and 241b, the seventh pad part 242a, and the eighth pad part 242b may include a same material. In addition, the fourth wiring part 241a and 241b, the seventh pad part 242a, and the eighth pad part 242b may be formed integrally.

The seventh pad part 242a may be disposed on the first surface 1S. The seventh pad part 242a may be disposed adjacent to the first pad part 212a. The seventh pad part 242a can be connected to a terminal of an external circuit board. Accordingly, the fourth circuit pattern 220 and the circuit board can be connected.

In addition, the eighth pad part 242b can be disposed on the second surface 2S. The eighth pad part 242b can be connected to a terminal of an external display panel. Accordingly, the fourth circuit pattern 240 and the display panel can be connected.

The fourth wiring part can include a fourth-first wiring part 241a and a fourth-second wiring part 241b. The fourth-first wiring part 241a is disposed on the first surface 1S. The fourth-second wiring part 241b is disposed on the second surface 2S. The fourth wiring part can connect the seventh pad part 242a and the eighth pad part 242b. In detail, the fourth-first wiring part 241a can be connected to the seventh pad part 242a. In addition, the fourth-second wiring part 241b can be connected to the eighth pad part 242b.

The fourth circuit pattern 240 can be a power supply pattern. Power can be transmitted to the circuit board and the display panel through the fourth circuit pattern 240.

The first protective layer 310 and the second protective layer 320 can be disposed on the fourth circuit pattern 240. In detail, the first protective layer 310 can be disposed on the fourth circuit pattern 240 on the first surface 1S. In addition, the second protective layer 320 may be disposed on the fourth circuit pattern 240 on the second surface 2S. The first protective layer 310 and the second protective layer 320 may be disposed on a region excluding the seventh pad part 242a and the eighth pad part 242b.

The fourth-first wiring part 241a and the fourth-second wiring part 241b may be connected to each other. In detail, the fourth-first wiring part 241a and the fourth-second wiring part 241b may be connected through the third via V3. The third via V3 may be disposed on the first surface 1S and the second surface 2S. The third via V3 on the first surface 1S and the third via V3 on the second surface 2S may be disposed at corresponding positions.

The third via V3 includes a third via land VL3 and a third via hole VH3. The third via hole VH3 is formed inside the third via land VL3. A conductive material may be disposed in the third via hole VH3. Accordingly, the fourth-first wiring part 241a and the fourth-second wiring part 241b may be electrically connected.

At least one of the first circuit pattern 210, the second circuit pattern 220, the third circuit pattern 230, and the fourth circuit pattern 240 may include a metal material having excellent electrical conductivity. In detail, at least one of the circuit patterns among the first circuit pattern 210, the second circuit pattern 220, the third circuit pattern 230, and the fourth circuit pattern 240 may include copper (Cu). However, the embodiment is not limited thereto. At least one of the circuit patterns among the first circuit pattern 210, the second circuit pattern 220, the third circuit pattern 230, and the fourth circuit pattern 240 may include at least one metal among copper (Cu), aluminum (Al), chromium (Cr), nickel (Ni), silver (Ag), molybdenum (Mo), gold (Au), titanium (Ti), and alloys thereof.

In addition, at least one of the first protective layer 310 and the second protective layer 320 may include a solder paste. For example, at least one of the first protective layer 310 and the second protective layer 320 may include a solder paste including a thermosetting resin, a thermoplastic resin, a filler, a curing agent, or a curing accelerator.

As described above, the second circuit pattern 220 may include a first via V1. In detail, the second circuit pattern 220 may include a plurality of first vias V1. A number of the first vias V1 may correspond to a number of pad parts of the second circuit pattern 220. Accordingly, the number of the first vias V1 may be proportional to a number of terminals of the display panel.

For example, when the flexible circuit board is connected to a display panel for VR having a large number of terminals, the number of the first vias V1 may increase. In addition, the first via V1 may be disposed in various ways according to a width in the first direction 1D and a length in the second direction 2D of the flexible circuit board.

For example, a plurality of first via groups VG1 may be defined. The first via group VG1 includes a plurality of first vias V1 disposed in the second direction 2D. In addition, the first via groups VG1 may be spaced apart in the first direction 1D.

The number of the first vias V1 of the first via group VG1 may vary depending on the width in the first direction 1D and the length in the second direction 2D of the flexible circuit board 1000. In addition, the number of the first via group VG1 may vary depending on the width in the first direction 1D and the length in the second direction 2D of the flexible circuit board 1000.

For example, when the width of the flexible circuit board 1000 is large, the number of the first vias V1 of the first via group VG1 can be decreased. In addition, the number of the first via group VG1 can be increased. For example, the flexible circuit board connected to a mobile display panel can have a large width. Accordingly, the flexible circuit board connected to the mobile display panel can have a small number of the first vias V1 of the first via group VG1. In addition, the number of the first via group VG1 can be increased.

Alternatively, when the width of the flexible circuit board 1000 is small, the number of the first vias V1 of the first via group VG1 can be increased. In addition, the number of the first via group VG1 can be decreased. For example, a flexible circuit board connected to a display panel for VR may have a small width. Accordingly, the flexible circuit board connected to the display panel for VR may have a large number of first vias V1 of the first via group VG1. In addition, the number of the first via group VG1 may be small.

Meanwhile, the flexible circuit board 1000 may include a first separation region IA1, a second separation region IA2, and a third separation region IA3. The first separation region IA1 may be defined as a region between the fourth pad part 222b and a first via V1 closest to the fourth pad part 222b. In addition, the second separation region IA2 may be defined as a region between the first via V1 closest to the fourth pad part 222b and the cutting line CL. In addition, the third separation region IA3 may be defined as a region between the sixth pad part 232b and the chip mounting region CHA.

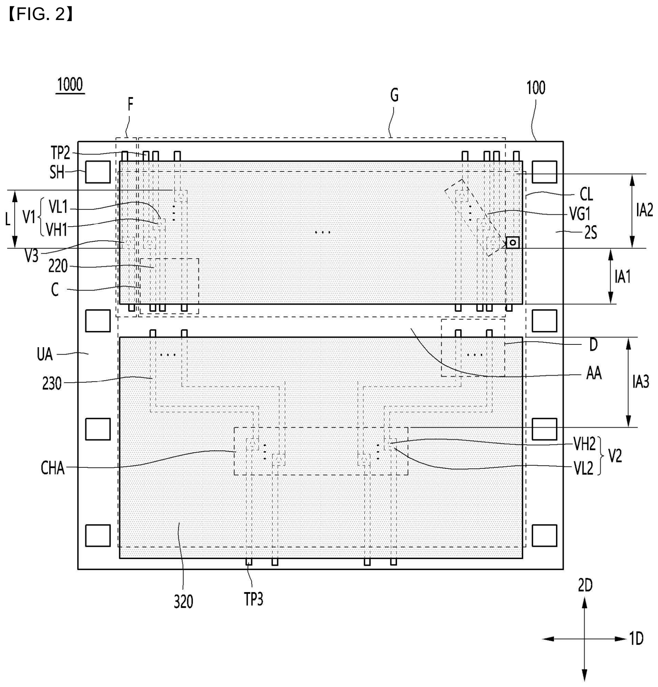

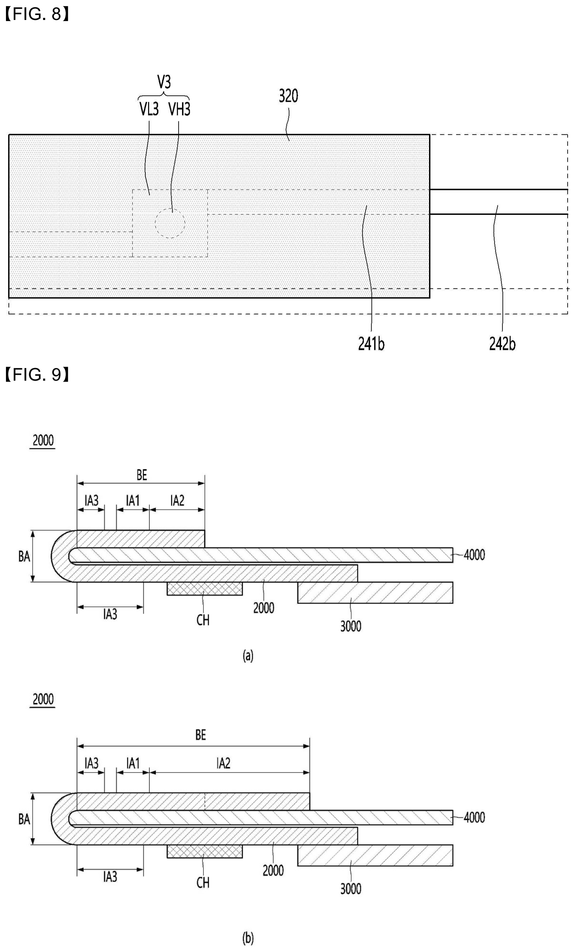

The COF module 2000 may be bent. In detail, referring to FIG. 2 and (a) and (b) of FIG. 9, the COF module 2000 may be bent in the third separation region IA3. Therefore, the COF module 2000 includes a bending region BA. In detail, the third separation region IA3 includes the bending region BA.

Accordingly, the first separation region IA1 and the second separation region IA2 may overlap with the display panel 4000. Accordingly, the first separation region IA1 and the second separation region IA2 may become a bezel region of the display panel 4000. Accordingly, as shown in (b) of FIG. 9, when the lengths of the first separation region IA1 and the second separation region IA2 increase, the bezel region of the display panel 4000 may increase.

For example, when the number of the first vias V1 of the first via group VG1 increases, a length of the second separation region IA2 may increase. Accordingly, the bezel region of the display panel 4000 may increase. For example, in the case of a COF module 2000 connected to a display panel for VR, the number of the first vias V1 of the first via group VG1 is large. Accordingly, the length of the second separation region IA2 becomes longer, so that the bezel region BE of the display panel 4000 may become larger.

Alternatively, if a size of the first via V1 of the first via group VG1 becomes larger, the bezel region of the display panel 4000 may become larger. For example, in a case of a COF module 2000 connected to a display panel for mobile, the number of the first vias V1 of the first via group VG1 is small. However, the size of the first via V1 may become larger. Accordingly, the length of the second separation region IA2 becomes longer, so that the bezel region BE of the display panel 4000 may become larger.

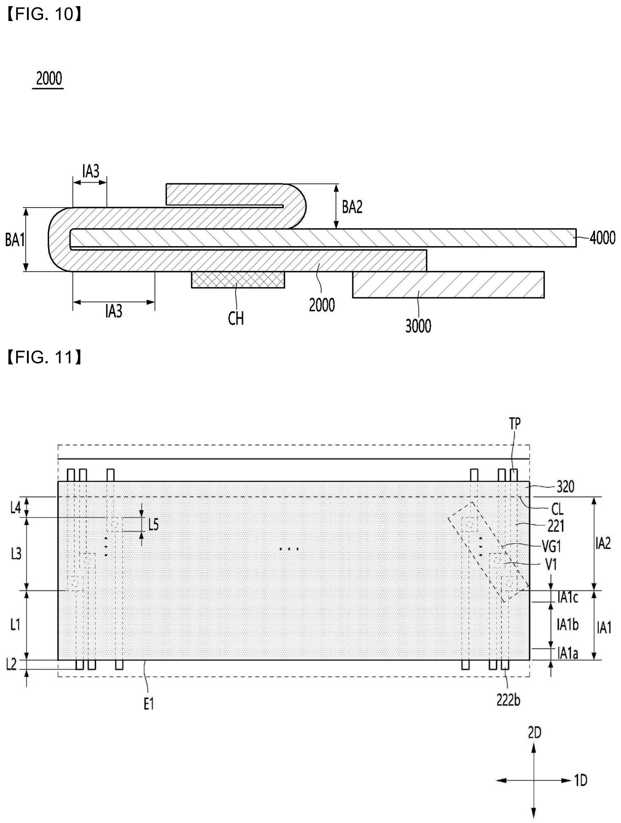

Accordingly, the COF module 2000 according to the embodiment can be bent in at least two regions. Referring to FIG. 10, the COF module 2000 can include a first bending region BA1 and a second bending region BA2. At this time, when the first via V1 is disposed in the second bending region BA2, stress can be transmitted to the first via V1. Accordingly, a size or shape of the first via land VL1 and the first via hole VH1 can change. Accordingly, an alignment of the first via hole VH1 can be misaligned.

Hereinafter, the flexible circuit board 1000 and the COF module that can solve the above problems will be described.

FIG. 11 is an enlarged drawing of region G of FIG. 2.

Referring to FIG. 11, the second circuit pattern 220 may have a length range set for each region. In detail, the second circuit pattern 220 may be defined as having a first length L1, a second length L2, a third length L3, a fourth length L4, and a fifth length L5.

The first length L1 may be defined as a length from an end E1 of the second protective layer 320 to the first via V1 closest to the fourth pad part 222b. That is, the first length L1 may be defined as a length from an end E1 of the second protective layer 320 to the first via V1 of the first via group VG1 closest to the end E1 of the second protective layer. In addition, the first length L1 may be defined as a length from the end of the fourth pad part 222b to the first via V1 of the first via group VG1 closest to the end of the fourth pad part 222b. The first length L1 may be defined as a length of the first separation region IA1.

In addition, the second length L2 may be defined as a length of the fourth pad part 222b.

In addition, the third length L3 may be defined as a length from the first via V1 closest to the fourth pad part 222b to the first via V1 farthest from the fourth pad part 222b. That is, the third length L3 may be defined as a length from a closest first via V1 of the first via group VG1 to a farthest first via V1 of the first via group VG1.

In addition, the fourth length L4 may be defined as a length from the first via V1 farthest from the fourth pad part 222b to the cutting line CL. That is, the fourth length L4 may be defined as a length from the farthest first via V1 of the first via group VG1 to the cutting line CL. That is, the fourth length L4 may be defined as a distance from the farthest first via V1 of the first via group VG1 to the end of the COF module.

A sum of the third length L3 and the fourth length V4 may be defined as a length of the second separation region IA2.

The first length L1 may be greater than the second length L2. For example, the first length L1 may be 1.5 times or more than the second length L2. In detail, the first length L1 may be 1.5 to 10 times, 2 to 5 times, or 2.5 to 3.5 times the second length L2.

In addition, the first length L1 may be greater than the length L5 of the first via V1. For example, the first length L1 may be 15 times or more than the length L5 of the first via V1. In detail, the first length L1 may be 15 to 35 times, 20 to 35 times, or 25 to 35 times the length L5 of the first via V1.

In addition, the first length L1 may be smaller than the third length L3. For example, the first length L1 may be 0.8 times or less of the third length L3. In detail, the first length L1 may be 0.3 to 0.8 times, 0.4 to 0.7 times, or 0.5 to 0.6 times of the third length L3.

In addition, the first length L1 may be greater than the fourth length L4. For example, the first length L1 may be 1.5 times or more the fourth length L4. In detail, the first length L1 may be 1.5 to 10 times, 2 to 9 times, or 3 to 8.5 times the fourth length L4.

For example, the first length L1 may be 5 mm or less. In detail, the first length L1 may be 0.1 to 4 mm, 0.5 to 3 mm, or 1 to 2.5 mm.

In addition, the second length L2 may be 0.5 to 1 mm, or 0.7 to 0.9 mm.

In addition, the third length L3 may be 1 to 4 mm, 2 to 3.5 mm, or 2.5 to 3.3 mm.

In addition, the fourth length L4 may be 0.15 mm to 0.6 mm, 0.2 mm to 0.5 mm, or 0.25 mm to 0.4 mm.

Since the first length L1 satisfies the above range, the flexible circuit board 1000 can be bent in the first separation region IA1. That is, a size of the first separation region IA1 is sufficiently secured. Therefore, the flexible circuit board 1000 can be bent at least once in the first separation region IA1.

The first separation region IA1 may include a first-first separation region IA1a, a first-second separation region IA1b, and a first-third separation region IA1c. The first-second separation region IA1b may be disposed between the first-first separation region IA1a and the first-third separation region IA1c.

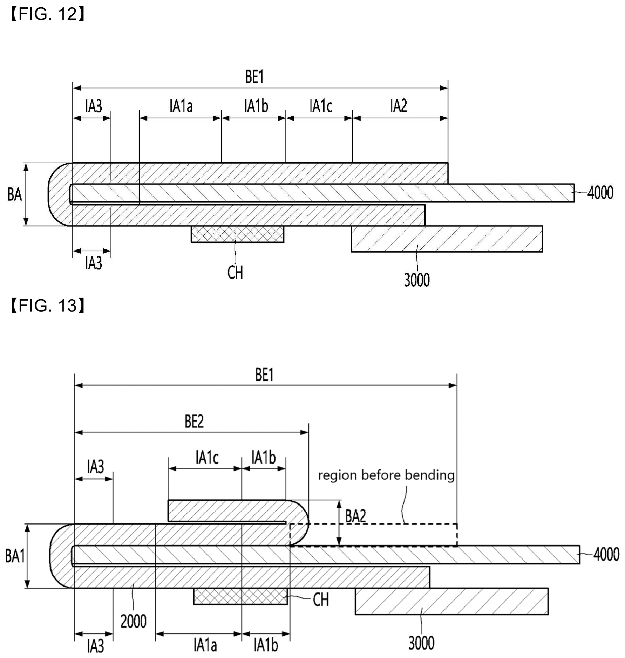

Referring to FIG. 13, the flexible circuit board 1000 may be bent at the third separation region IA3 and the first-second separation region IA1b. Accordingly, the bezel region of the display panel 4000 may be reduced.

Referring to FIG. 12, the flexible circuit board 1000 includes a bending region BA. In detail, the third separation region IA3 includes the bending region BA. If the flexible circuit board 1000 is bent only at the third separation region IA3, a first bezel region BE1 of the display panel 4000 may be increased. In detail, the first bezel region BE1 includes a part of the third separation region IA3, the first-first separation region IA1a, the first-second separation region IA1b, the first-third separation region IA1c, and the second separation region IA2.

However, referring to FIG. 13, the flexible circuit board 1000 includes a first bending region BA1 and a second bending region BA2. The third separation region IA3 includes the first bending region BA1. In addition, the first-second separation region IA1b includes the second bending region BA2. If the third separation region IA3 and the first-second separation region IA1b are bent, a second bezel region BE2 of the display panel 4000 is reduced. In detail, the second bezel region BE2 includes a part of the third separation region IA3, the first-first separation region IA1a, and a part of the first-second separation region IA1b.

In FIG. 13, the first-second separation region IA1b is shown to be bent only once. However, the embodiment is not limited thereto. For example, the first-second separation region IA1b may be bent at least twice. That is, the first-second separation region IA1b may include at least two bending regions.

The flexible circuit board 1000 according to the embodiment is bent at the first separation region IA1. Therefore, the bezel region of the display panel can be reduced.

In addition, the flexible circuit board is not bent at the second separation region IA2. Accordingly, the flexible circuit board 1000 does not bend in a region where the first via V1 is formed.

Therefore, when the flexible circuit board 1000 is bent, stress can be prevented from being transmitted to the first via. Therefore, an alignment of the first via can be prevented from being misaligned due to the stress. In addition, the shape or size of the first via can be prevented from changing.

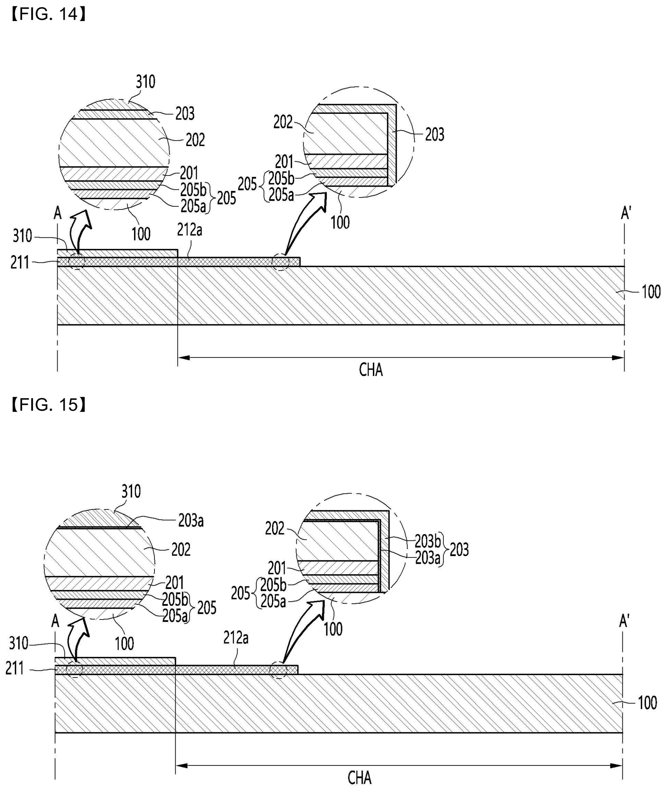

Hereinafter, with reference to FIGS. 14 and 15, layer structures of the first circuit pattern, the second circuit pattern, the third circuit pattern, and the fourth circuit pattern will be described. For convenience of explanation, the description will be centered on the first circuit pattern. The description below applies to all of the second circuit pattern, the third circuit pattern, and the fourth circuit pattern.

Referring to FIG. 14, the first circuit pattern can be formed in multiple layers. In detail, the first wiring part 211 and the first pad part 212a may include a first metal layer 201 and a second metal layer 202. In addition, although not shown in FIG. 14, the second pad part 212b may also include the first metal layer 201 and the second metal layer 202.

The first metal layer 201 may be a seed layer of the first circuit pattern. For example, the first metal layer 201 may be formed on the substrate 100 through electroless plating using a metal material such as copper (Cu).

In addition, the second metal layer 202 may be a plating layer. For example, the second metal layer 202 is formed through electrolytic plating using the first metal layer 201 as a seed layer.

A thickness of the first metal layer 201 may be smaller than a thickness of the second metal layer 202.

For example, the thickness of the first metal layer 201 may be 0.7 µm to 2 µm. The thickness of the second metal layer 202 may be 10 µm to 25 µm.

The first metal layer 201 and the second metal layer 202 may include a same metal material. For example, the first metal layer 201 and the second metal layer 202 may include copper (Cu).

In addition, a bonding layer 203 may be disposed on the second metal layer 201. In detail, the bonding layer 203 may be disposed on a side surface of the first metal layer 201, a side surface of the second metal layer 202, and an upper surface of the second metal layer 202. That is, the bonding layer 203 may be disposed while surrounding the first metal layer 201 and the second metal layer 202.

The bonding layer 203 may include a metal. In detail, the bonding layer 203 may include tin (Sn).

The bonding layer 203 may be formed with a thickness of 0.3 µm to 0.7 µm. A content of tin may increase as the bonding layer 203 extends from a lower surface to an upper surface.

That is, the bonding layer 203 is disposed while contacting the second metal layer 202. Accordingly, a content of tin may increase and a content of copper may decrease as the bonding layer 203 extends from the lower surface to the upper surface.

Accordingly, only pure tin may remain in a thickness range of 0.1 µm to 0.3 µm on the upper surface of the bonding layer 203.

By the bonding layer 203, the chip terminal, the circuit board terminal, the terminal of the display panel, and the pad part can be easily bonded through heat and pressure. That is, when heat and pressure are applied to the pad part, the upper surface of the bonding layer where pure tin remains is melted. As a result, the chip terminal, the circuit board terminal, and the terminal of the display panel can be easily bonded.

Accordingly, the bonding layer 203 can be a part of the first pad part 212a and a part of the second pad part 222b.

The first circuit pattern can be disposed with a thickness of 2 µm to 25 µm. For example, the first circuit pattern can be disposed with a thickness of 5 µm to 20 µm. For example, the first circuit pattern can be disposed with a thickness of 7 µm to 15 µm.

When forming the first circuit pattern, flash etching is performed to separate the circuit patterns. As a result, the first metal layer 201 is etched. Accordingly, the thickness of the first circuit pattern finally manufactured may be smaller than ta sum of the thicknesses of the first metal layer 201, the second metal layer 202, and the bonding layer 203 formed during the process.

If the thickness of the first circuit pattern is less than 2 µm, the resistance of the second circuit pattern may increase. If the thickness of the first circuit pattern exceeds 25 µm, it may be difficult to implement a fine pattern.

Meanwhile, a buffer layer 205 may be further disposed between the substrate 100 and the first circuit pattern. The buffer layer 205 may improve the adhesion between the substrate 100 and the first circuit pattern, which are different materials.

The buffer layer 205 may be formed in multiple layers. In detail, a first buffer layer 205a and a second buffer layer 205b on the first buffer layer 205a may be disposed on the substrate 100. Accordingly, the first buffer layer 205a may be in contact with the substrate 100. The second buffer layer 205b may be in contact with the first circuit pattern 210.

The first buffer layer 205a may include a material having good adhesion to the substrate 100. For example, the first buffer layer 205a may include nickel (Ni). In addition, the second buffer layer 205b may include a material having good adhesion to the second circuit pattern. For example, the second buffer layer 205b may include chromium (Cr).

The buffer layer 205 may have a thin film thickness in nanometer units. For example, the buffer layer 205 may have a thickness of 20 nm or less.

The adhesion between the substrate 100 and the first circuit pattern, which are different materials may be improved by the buffer layer 205. As a result, the first circuit pattern may be prevented from being delaminated.

Referring to FIG. 15, the bonding layer 203 may include a plurality of bonding layers. For example, the bonding layer 203 may include a first bonding layer 203a and a second bonding layer 203b.

In detail, the first bonding layer 203a may be disposed on the first wiring part 211, the first pad part 212a, and the second pad part 212b.

In addition, the second bonding layer 203b may be disposed only on the first pad part 212a and the second pad part 212b. That is, the first wiring part 211, the first pad part 212a, and the second pad part 212b may have different layer structures due to the second bonding layer 203b.

The first bonding layer 203a and the second bonding layer 203b may include a metal. In detail, the first bonding layer 203a and the second bonding layer 203b may include tin (Sn).

The first bonding layer 203a and the second bonding layer 203b may be disposed with different thicknesses. In detail, the second bonding layer 203b may be thicker than the first bonding layer 203a.

For example, the first bonding layer 203a may have a thin film thickness of 0.02 µm to 0.06 µm. The second bonding layer 203b may have a thickness of 0.2 µm to 0.6 µm.

If the bonding layer is thickly disposed in a region between the protective layer 300 and the first wiring part 211, cracks may occur when the flexible circuit board is bent. Accordingly, the first bonding layer 203a may be formed with a thin film thickness. This may prevent cracks from occurring when the flexible circuit board is bent.

In addition, the content of tin may increase as the second bonding layer 203b extends from the lower surface to the upper surface.

That is, the second bonding layer 203b may have a tin content that increases from the lower surface to the upper surface, and a copper content that decreases.

Accordingly, only pure tin may remain in a thickness range of 0.1 µm to 0.3 µm on the upper surface of the second bonding layer 203b.

The terminal of the chip, the terminal of the circuit board, the terminal of the display panel, and the pad part may be easily bonded by the second bonding layer 203b through heat and pressure. That is, when heat and pressure are applied to the pad part, the upper surface of the bonding layer where pure tin remains is melted. As a result, the terminal of the chip, the terminal of the circuit board, and the terminal of the display panel may be easily bonded.

The flexible circuit board may be bent into various shapes. The COF module 2000 may be bent into various shapes.

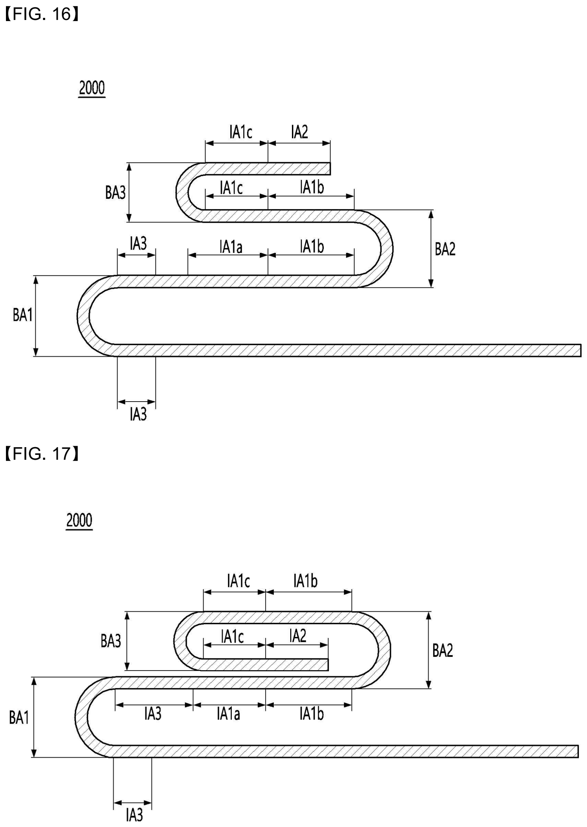

FIGS. 16 to 19 are drawings illustrating various shapes in which a COF module including a flexible circuit board according to an embodiment is bent.

Referring to FIGS. 16 to 19, the COF module 2000 can be bent at least three times. For example, referring to FIGS. 16 to 18, the COF module 2000 can be bent three times. That is, the COF module 2000 can include a first bending region BA1, a second bending region BA2, and a third bending region BA3.

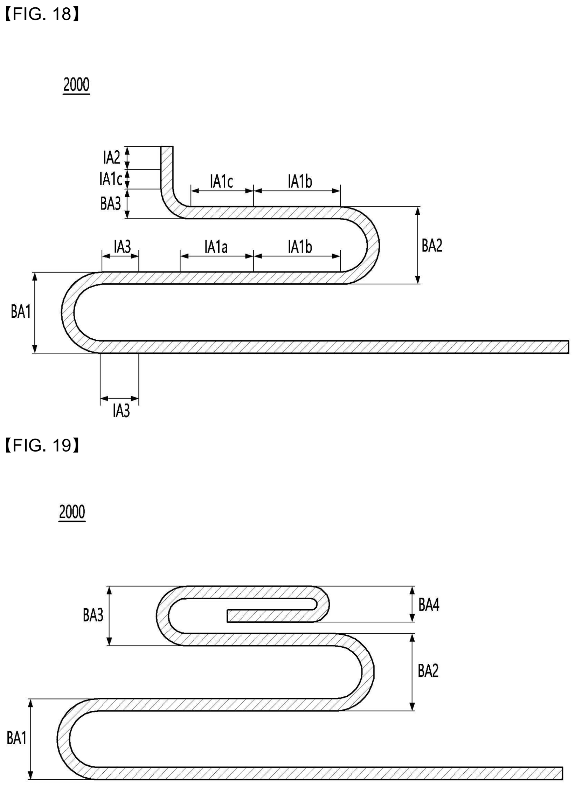

Alternatively, referring to FIG. 19, the COF module 2000 can be bent four times. That is, the COF module 2000 can include a first bending region BA1, a second bending region BA2, a third bending region BA3, and a fourth bending region BA4.

In detail, the COF module 2000 is bent in the first separation region IA1 and the third separation region IA3. For example, the COF module is bent twice in the first separation region IA1 and once in the third separation region IA3. In addition, the COF module is not bent in the second separation region IA2 where the vias are disposed.

Therefore, when the COF module 2000 is bent, the vias can be prevented from being deformed. In addition, since the COF module 2000 is bent in the first separation region IA1, a size of the bezel region of the display panel connected to the COF module can be reduced.

In addition, referring to FIGS. 16 to 19, the first separation region IA1 and the third separation region IA3 can be bent at a same or different curvatures. For example, referring to FIG. 18, the first separation region IA1 and the third separation region IA3 can be bent at different curvatures.

The flexible circuit board according to the embodiment can form a COF module by mounting a chip (CH) on the chip mounting region CHA and cutting the cutting line CL.

The COF module 2000 is positioned between the display panel 4000 and the circuit board 3000 and can connect an electrical signal.

Referring to FIG. 13, one end of the COF module 2000 according to the embodiment is connected to the display panel 4000. In addition, another end opposite to the one end is connected to the circuit board 3000. For example, the display panel 4000 is disposed on one surface of the COF module 2000. In addition, the circuit board 3000 may be disposed on another surface opposite to the one surface of the COF module 2000. However, the embodiment is not limited thereto. The display panel 4000 and the circuit board 3000 may be disposed on a same surface of the COF module 2000.

The COF module 2000 includes a flexible substrate. Accordingly, it may have both a rigid form and a bent form between the display panel 3000 and the circuit board 4000.

The COF module 2000 may connect the display panel 4000 and the circuit board 3000 that are disposed opposite each other in a bent form. Therefore, a thickness of the electronic device can be reduced. In addition, a degree of freedom of design can be improved. In addition, the COF module 2000 including the flexible substrate does not have wire breakage even in a bent form. Accordingly, the reliability of the electronic device can be improved.

In addition, since the COF module 2000 is bent in the first separation region IA1, the bezel region of the display panel 4000 can be reduced. In addition, since the COF module 2000 is not bent in the second separation region IA1, deformation of the via can be prevented.

Since the COF module is flexible, the COF module can be used in various electronic devices.

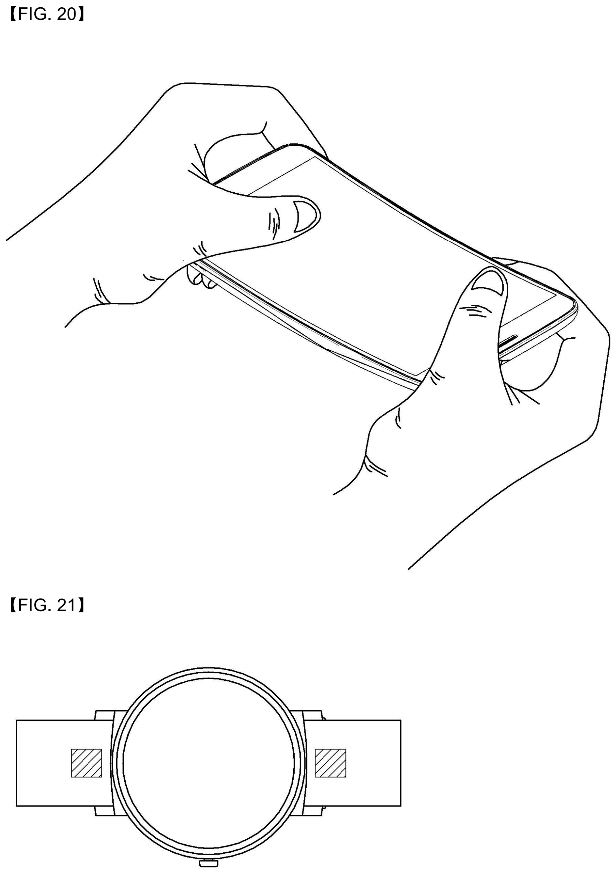

For example, referring to FIG. 20, the COF module can be applied to a flexible touch window that bends. Therefore, a touch device including the COF module can be a flexible touch device.

Referring to FIG. 21, the COF module can be applied to various wearable touch devices including a curved display. Accordingly, a wearable touch device can be slimmed down or made lightweight.

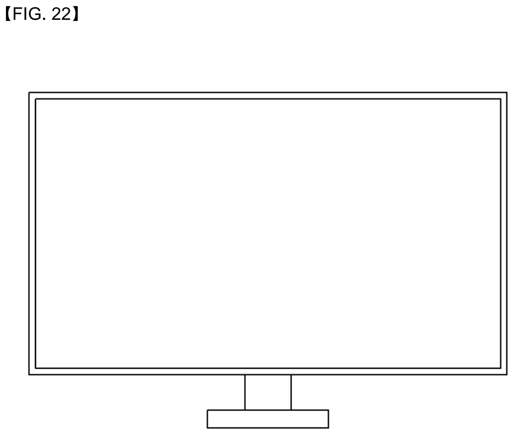

Referring to FIG. 22, the COF module can be applied to various electronic devices having a display portion, such as a TV, a monitor, and a laptop.

The characteristics, structures and effects described in the embodiments above are included in at least one embodiment but are not limited to one embodiment. Furthermore, the characteristics, structures, and effects and the like illustrated in each of the embodiments may be combined or modified even with respect to other embodiments by those of ordinary skill in the art to which the embodiments pertain. Thus, it should be construed that contents related to such a combination and such a modification are included in the scope of the embodiment.

The above description has been focused on the embodiment, but it is merely illustrative and does not limit the embodiment. A person skilled in the art to which the embodiment pertains may appreciate that various modifications and applications not illustrated above are possible without departing from the essential features of the embodiment. For example, each component particularly represented in the embodiment may be modified and implemented. In addition, it should be construed that differences related to such changes and applications are included in the scope of the embodiment defined in the appended claims.

## Claims

1. A flexible circuit board comprising:
a substrate including a first surface and a second surface opposite to the first surface;
a first circuit pattern disposed on the first surface;
a second circuit pattern disposed on the first surface and the second surface;
a third circuit pattern disposed on the first surface and the second surface;
a first protective layer disposed on the first surface; and
a second protective layer disposed on the second surface,
wherein a chip mounting region is defined on the first surface,
wherein the first circuit pattern includes a first pad part connected to a chip on the chip mounting region; a second pad part connected to an external printed circuit board; and a first wiring part connected to the first pad part and the second pad part,
wherein the second circuit pattern includes a third pad part connected to the chip; a fourth pad part connected to an external display panel; and a second wiring part connected to the third pad part and the fourth pad part,
wherein the third circuit pattern includes a fifth pad part connected to the chip; a sixth pad part connected to the display panel; and a third wiring part connected to the fifth pad part and the sixth pad part,
wherein the second circuit pattern includes a first via connecting a second wiring part on the first surface and a second wiring part on the second surface,
wherein the second wiring part is defined by a first length which is a distance from an end of the fourth pad part to a first via closest to the fourth pad part; and a second length which is a length of the fourth pad part, and
wherein the first length is longer than the second length.

2. The flexible circuit board of claim 1, wherein the first length is 1.5 to 10 times the second length.

3. The flexible circuit board of claim 1, wherein the second circuit pattern defines a third length, which is a length from the first via closest to the fourth pad part to a first via farthest from the fourth pad part, and
wherein the first length is 0.3 to 0.8 times the third length.

4. The flexible circuit board of claim 1, wherein the substrate defines a cutting line,
wherein a fourth length, which is a length from a first via farthest from the fourth pad part to the cutting line, and
wherein the first length is 1.5 to 10 times the fourth length.

5. The flexible circuit board of claim 1, wherein the first length is 15 to 35 times a length of the first via.

6. The flexible circuit board of claim 1, wherein the first length is 0.1 mm to 4 mm.

7. The flexible circuit board of claim 1, wherein the second length is 0.5 mm to 1 mm,
wherein the third length is 1 mm to 4 mm, and
wherein the fourth length is 0.15 mm to 0.6 mm.

8. The flexible circuit board of claim 1, wherein the substrate has a cutting line defined, and includes a first separation region defined as a region between the fourth pad part and the first via closest to the fourth pad part; a second separation region defined as a region between the fourth pad part and a first via closest to the cutting line; and a third separation region defined as a region between the sixth pad part and the chip mounting region, and
wherein at least one of the first separation region and the second separation region is bent.

9. The flexible circuit board of claim 8, wherein the first separation region and the third separation region are bent, and
wherein the first separation region is bent at least once.

10. The flexible circuit board of claim 8, wherein the second separation region is not bent.
